(19) Europäisches Patentamt
European Patent Office
Office européen des brevets

(11) **EP 2 848 816 B1**

(12) **EUROPÄISCHE PATENTSCHRIFT**

(45) Veröffentlichungstag und Bekanntmachung des Hinweises auf die Patenterteilung:
**18.04.2018 Patentblatt 2018/16**

(51) Int Cl.:
*F04D 19/04* (2006.01)          *F04D 27/02* (2006.01)
*F04D 29/66* (2006.01)          *F04B 37/14* (2006.01)
*F04B 37/08* (2006.01)          *H01J 37/32* (2006.01)
*F04D 29/058* (2006.01)        *F04D 25/06* (2006.01)

(21) Anmeldenummer: **14183255.0**

(22) Anmeldetag: **02.09.2014**

(54) **Anordnung mit einer Turbomolekularpumpe sowie Verfahren zur Kompensation eines Magnetfeldes wenigstens eines in einer Turbomolekularpumpe angeordneten, ein magnetisches Störfeld erzeugenden Bauteiles**

Assembly with a turbomolecular vacuum pump and method for compensating for a magnetic field of at least one component creating a magnetic interference field arranged in a turbomolecular vacuum pump

Agencement doté d'une pompe à vide turbomoléculaire et procédé de compensation d'un champ magnétique d'au moins un élément produisant un champ magnétique parasite disposé dans une pompe à vide turbomoléculaire

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2013 DE 102013110251**

(43) Veröffentlichungstag der Anmeldung:
**18.03.2015 Patentblatt 2015/12**

(73) Patentinhaber: **Pfeiffer Vacuum GmbH**
**35614 Aßlar (DE)**

(72) Erfinder: **Conrad, Armin**
**35745 Herborn (DE)**

(74) Vertreter: **Knefel, Cordula**
**Wertherstrasse 16**
**35578 Wetzlar (DE)**

(56) Entgegenhaltungen:
**EP-A2- 2 544 214          DE-T2- 60 210 482**
**JP-A- 2003 173 755**

**Beschreibung**

Die Erfindung betrifft eine Anordnung mit einer Turbomolekularpumpe sowie ein Verfahren zur Kompensation eines Magnetfeldes wenigstens eines in einer Turbomolekularpumpe angeordneten, ein magnetisches Störfeld erzeugenden Bauteiles, beispielsweise eines Magnetlagers und/oder Motors.

Seit Jahrzehnten werden Turbomolekularpumpen in der Vakuumtechnik zur Erzeugung von Hochvakuum und Ultrahochvakuum eingesetzt. Die Vakuumerzeugung beruht in ihnen auf einem Rotor mit mehreren entlang der Rotorachse zueinander versetzten Schaufelkränzen, zwischen denen statorseitig stehende Schaufelkränze angeordnet sind.

Üblicherweise werden die Rotoren in den Turbomolekularpumpen mittels wenigstens eines Magnetlagers, welches radial angeordnet ist, drehbar gelagert. Axial werden diese Magnetlager häufig von einem zweiten Lager, beispielsweise einem Kugellager, welches eine axiale und radiale Stabilisierung gewährleistet, unterstützt.

Eine derartige Turbomolekularpumpe ist beispielsweise aus der DE 10 2010 052 660 A1 bekannt.

Die Magnetlager bestehen üblicherweise aus mehreren Ringen, die einen spulenförmigen Aufbau aufweisen. Die Homogenität der Ringe wird vor dem Einbau in der Turbomolekularpumpe gemessen und die Ringe werden gemäß der Praxis derart aufeinander abgestimmt, dass sich die Inhomogenitäten der einzelnen Ringe so weit wie möglich aufheben.

Vollständig aufheben lassen sich diese Inhomogenitäten jedoch häufig nicht, so dass ein resultierendes Magnetfeld beim Betrieb der Turbomolekularpumpe entsteht.

Bei vielen Anwendungen, die aus der Praxis bekannt sind, stören derartige Magnetfelder nicht, zumal diese relativ klein sind.

Werden Turbomolekularpumpen jedoch an hochempfindlichen Geräten, beispielsweise zur Evakuierung einer Untersuchungskammer eines Elektronenmikroskopes eingesetzt, können die magnetischen Störfelder, die beispielsweise von den Magnetlagern und/oder von einem Motor verursacht werden, zu einem sogenannten Verwischungsgrad, das heißt, einer gewissen Bildunschärfe führen.

Aus dem Stand der Technik (EP 2 544 214 A2) ist eine integrierbare Magnetfeldkompensation für den Einsatz an Raster- und Transmissionselektronenmikroskopen bekannt. Bei diesem Stand der Technik erfolgt eine Anordnung einer Kompensationsspule an der Vakuumkammer.

Weiterhin gehört zum Stand der Technik (JP 2003 173 755) ebenfalls ein Rasterelektronenmikroskop, bei dem ebenfalls im Bereich der Probe Kompensationsspulen vorgesehen sind.

Außerdem ist aus dem Stand der Technik (DE 10 2010 013 675 A1) ein Axialmagnetlager mit integrierten Kompensationsspulen zur Kompensation eines von der Hauptspule des Axialmagnetlagers erzeugten magnetischen Störfeldes bekannt. Die Kompensationsspulen sind unmittelbar anliegend an einem Joch angeordnet, und eine Hauptspule ist in diesem Joch angeordnet. Die Kompensationsspule ist nicht entfernt liegend von dem Axialmagnetlager angeordnet.

Darüber hinaus ist aus dem Stand der Technik (US 2007/0,164,627) eine Vorrichtung zur magnetischen Aufhängung eines Rotors in Bezug zu einem Gehäuse offenbart mit axialen Magnetlagern, die eine Hauptspule eines Elektromagneten aufweisen und eine Ausgleichsspule, die in unmittelbarer Nähe zu der Hauptspule des Elektromagneten angeordnet ist. Die Hauptspule wie auch die Ausgleichsspule sind gemeinsam in einem Stator angeordnet.

Das der Erfindung zugrunde liegende technische Problem besteht darin, eine Turbomolekularpumpe anzugeben, bei der das mögliche magnetische Störfeld wenigstens eines Bauteiles, beispielsweise eines Magnetlagers und/oder eines Motors kompensiert wird sowie ein Verfahren zu einer Kompensation eines magnetischen Störfeldes wenigstens eines in einer Turbomolekularpumpe angeordneten Bauteiles, beispielsweise Magnetlagers und/oder Motors anzugeben, welches einfach und preiswert in der Umsetzung ist.

Dieses technische Problem wird durch eine Turbomolekularpumpe mit den Merkmalen gemäß Anspruch 1 sowie durch ein Verfahren mit den Merkmalen gemäß Anspruch 9 gelöst.

Die erfindungsgemäße Anordnung mit einer Turbomolekularpumpe mit einem Rotor und mit einem zum Antrieb des Rotors vorgesehenen Motor zeichnet sich dadurch aus, dass wenigstens eine Kompensationsspule zur Kompensation eines von einem Bauteil der Turbomolekularpumpe erzeugten magnetischen Störfeldes vorgesehen ist und dass die wenigstens eine Kompensationsspule in und/oder an der Turbomolekularpumpe, entfernt liegend von dem Bauteil, angeordnet ist.

Das ein magnetische Störfeld erzeugende Bauteil kann beispielsweise wenigstens ein Magnetlager sein, mit dem der Rotor drehbar gelagert ist. Das magnetische Störfeld kann auch von dem Motor, der den Rotor antreibt, verursacht werden. Die Anwendung der Erfindung ist jedoch nicht auf diese Bauteile beschränkt.

Vorteilhaft wird mit der wenigstens einen Kompensationsspule ein Feldvektor ($\vec{B}_K$) mit einstellbarer Amplitude und Richtung erzeugt. Durch die Anordnung der wenigstens einen zusätzlichen Spule wird in der Spule durch einen Strom in der Spule ein Feldvektor $\vec{B}$ mit einstellbarer Amplitude und Richtung erzeugt, mit dem das magnetische Störfeld des wenigstens einen Bauteiles der Turbomolekularpumpe kompensiert wird.

Vorteilhaft ist vorgesehen, dass die Kompensationseinrichtung als eine aus einer Antriebselektronik der Turbomolekularpumpe eine rotationssynchrone Kompensations-Grundfrequenz sowie erste bis n-te Oberschwingungen mit $n \geq 2$ ableitende Kompensationseinrichtung ausgebildet ist.

Gemäß einer vorteilhaften Ausführungsform der Erfindung sind drei Spulen zur Kompensation des Magnetfeldes des wenigstens einen Bauteiles der Turbomolekularpumpe angeordnet.

Durch die drei Spulen ist es möglich, bei entsprechender Anordnung der Spulen in jeder Raumrichtung (X, Y, Z) eine Kompensation vorzunehmen, da der Feldvektor des magnetischen Störfeldes ein gerichteter Vektor ist.

Die Spulen sind vorteilhaft derart zueinander angeordnet, dass die Magnetfelder der Spulen nicht parallel zueinander ausgerichtet sind, das heißt, die Magnetfelder der drei Kompensationsspulen sind vorteilhaft in drei Raumrichtungen zueinander ausgerichtet. Gemäß einer besonders bevorzugten Ausführungsform der Erfindung sind die drei Spulen jeweils im 90°-Winkel zueinander angeordnet. Vorteilhaft ist eine Spule mit ihrer Spulenebene senkrecht zu einer Rotorachse angeordnet und die zwei anderen Spulen sind jeweils senkrecht zu der ersten Spule und zu der anderen Spule angeordnet, also ist die zweite Spule vorteilhaft parallel zur Rotorachse angeordnet und die dritte Spule jeweils um 90° verdreht zu den ersten beiden Spulen.

Es kann ausreichend sein, das magnetische Störfeld lediglich in einer Ebene zu kompensieren. Bessere Ergebnisse werden jedoch erzielt, wenn das magnetische Störfeld im Wesentlichen vollständig kompensiert wird, das heißt, jeder Raumrichtung X, Y und Z wird wenigstens eine Kompensationsspule zugeordnet, so dass ein magnetisches Störfeld in den drei beziehungsweise in allen Raumrichtungen X, Y und Z kompensierbar ist.

Es ist hierbei möglich, jeder Raumrichtung X, Y und Z oder wenigstens einer Raumrichtung X, Y oder Z lediglich eine einzelne Kompensationsspule zuzuordnen. Jeder einzelnen Kompensationsspule kann auch wenigstens eine weitere Spule, vorzugsweise auf der gleichen Achse zugeordnet sein. Es wird in diesem Fall ein Kompensationsspulenpaar gebildet. In einer Ausführungsform der Erfindung ist dabei jeder Raumrichtung wenigstens ein Kompensationsspulenpaar zugeordnet, so dass ein magnetisches Störfeld in allen Raumrichtungen X, Y und Z kompensierbar ist.

Das Kompensationsspulenpaar kann derart angeschlossen und/oder ansteuerbar sein, dass lediglich eine einzelne Kompensationsspule des Kompensationsspulenpaares mit Strom versorgt werden kann.

Gemäß einer weiteren vorteilhaften Ausführungsform ist die wenigstens eine Kompensationsspule aus wenigstens einer Windung eines elektrischen Leiters gebildet. Dies ist die einfachste Art und Weise, eine Kompensationsspule aufzubauen.

Gemäß einer weiteren vorteilhaften Ausführungsform ist wenigstens ein Sensor zum Erfassen oder Messen des magnetischen Störfeldes vorgesehen. Wird das magnetische Störfeld erfasst, kann die wenigstens eine Kompensationsspule derart angesteuert werden, dass das magnetische Störfeld weitgehend oder vollständig kompensiert wird.

Gemäß einer weiteren vorteilhaften Ausführungsform der Erfindung ist neben der Kompensationsspule zum Generieren eines magnetischen Kompensationsfeldes wenigstens eine Stromversorgung für die wenigstens eine Kompensationsspule vorgesehen. Darüber hinaus ist es sinnvoll, eine Kompensationseinrichtung zum Steuern und/oder Regeln des Stromes in der wenigstens einen Spule in Abhängigkeit vom erfassten und/oder gemessenen magnetischen Störfeld vorzusehen.

Mit der wenigstens einen Spule wird vorteilhaft ein Feldvektor $\vec{B}$ mit einstellbarer Amplitude und Richtung erzeugt, um ein entsprechendes Kompensationsfeld zu erzeugen.

Die Kompensationseinrichtung ist vorteilhaft derart ausgebildet, dass die Kompensationseinrichtung aus einer Antriebselektronik der Turbomolekularpumpe eine rotationssynchrone Kompensationsgrundfrequenz sowie erste bis n-te Oberschwingungen ableitet mit $n \geq 2$.

Es werden so viele Oberschwingungen abgeleitet, wie für eine sinnvolle Kompensation notwendig sind.

Die Kompensationselektronik kann auch über eine Induktionsspule die rotationssynchrone Kompensationsgrundfrequenz ableiten. Mit einer Amplituden- und Phasenvariation der Ströme in der wenigstens einen Spule lässt sich das resultierende Feld minimieren und damit lässt sich auch die Bahnstörung auf bewegte Ladungen, wie in einem Elektronenmikroskop ebenfalls minimieren.

Die Amplituden- und Phasenvariation der Ströme in den Spulen sieht folgendermaßen aus:

$$i_Z = i_{Z0} \cdot sin(\omega_0 \cdot t + \varphi_0) + i_{Z1} \cdot \sin(2\omega_0 \cdot t + \varphi_1) + i_{Z2} \cdot \sin(3\omega_0 \cdot t + \varphi_2) + \dots$$

Dies gilt für die Z-Richtung und die gleiche Gleichung ist in X- und Y-Richtung anzusetzen.

Der Null- beziehungsweise Minimumabgleich erfolgt entweder automatisch oder durch gezielte Variation der oben genannten Parameter und Detektion des resultierenden magnetischen Störfeldes mit einem Magnetfeldsensor oder durch Beobachtung des Verwischungsgrades am Endgerät, beispielsweise am Elektronenmikroskop.

Vorteilhaft ist ein Sensor zur Erfassung der Phasenreferenz vorgesehen.

Die Kompensation des Feldes muss nämlich derart erfolgen, dass sie um 180° phasenverschoben zu dem Störsignal des Magnetfeldes ist.

Wie schon ausgeführt, ist das das magnetische Störfeld erzeugende Bauteil beispielsweise als Magnetlager oder als Elektromotor ausgebildet. Das Magnetlager kann als Permanentmagnetlager oder als aktives Magnetlager ausgebildet sein. Es ist auch möglich, magnetische Störfelder anderer Bauteile in der Turbomolekularpumpe zu kompensieren.

Gemäß der Erfindung ist die wenigstens eine Kompensationsspule in und/oder an der Turbomolekularpumpe angeordnet. Hierdurch ergibt sich eine kompakte Bauweise der erfindungsgemäßen Anordnung.

Turbomolekularpumpen weisen einen Aufbau auf, bei dem in einem Gehäuse ein mehrstufiger turbinenartiger Rotor mit beschaufelten Scheiben rotiert. Zwischen den Rotorscheiben sind ebenfalls beschaufelte Statorscheiben mit ähnlicher Geometrie spiegelverkehrt angeordnet. Die Rotoren sind vorteilhaft mit zwei Lagern, beispielsweise zwei Kugellagern gelagert. Wegen der Schmierstoffe müssen in diesem Fall beide Lager auf der Vorvakuumseite angeordnet werden.

Es besteht auch die Möglichkeit, eine Hybridlagerung vorzunehmen, das heißt, dass zwei Lagerungskonzepte zum Einsatz in einer einzigen Pumpe kommen. Ein mit Öl geschmiertes Kugellager sitzt hierbei beispielsweise am Wellenende auf der Vorvakuumseite, und auf der Hochvakuumseite ist ein wartungs- und verschleißfreies Permanentmagnetlager, das den Rotor radial zentriert, angeordnet.

Zum Antrieb der Rotoren nutzt man vorteilhaft kollektorlose Gleichstrommotoren, die mit elektronischen Antriebsgeräten Rotationsfrequenzen bis zu 1.500 Hz (90.000 Umdrehungen pro Minute) ermöglichen. Damit werden die zum Pumpen der Gase erforderlichen Schaufelgeschwindigkeiten erreicht.

Das erfindungsgemäße Verfahren zur Kompensation eines magnetischen Magnetfeldes wenigstens eines in einer Turbomolekularpumpe angeordneten, ein magnetisches Störfeld erzeugenden Bauteiles der Turbomolekularpumpe zeichnet sich dadurch aus, dass wenigstens eine Kompensationssspule ein magnetisches Störfeld des wenigstens einen Bauteiles der Turbomolekularpumpe kompensiert, und dass die wenigstens eine Kompensationsspule in und/oder an der Turbomolekularpumpe, entfernt liegend von dem Bauteil, angeordnet ist.

Das Bauteil kann beispielsweise ein Antriebsmotor und/oder wenigstens ein Magnetlager zur Lagerung des Rotors sein.

Das erfindungsgemäße Verfahren weist den Vorteil auf, dass ein magnetisches Störfeld von Spulen beispielsweise des wenigstens einen Magnetlagers und/oder des Motors durch ein von wenigstens einer Kompensationsspule erzeugten Magnetfeldes kompensiert wird. Damit werden empfindliche Geräte, wie zum Beispiel Elektronenmikroskope nicht von magnetischen Störfeldern der Bauteile der Turbomolekularpumpe negativ beeinflusst.

Gemäß einer besonders bevorzugten Ausführungsform der Erfindung sind drei Spulen vorgesehen, um das magnetische Störfeld des wenigstens einen Bauteiles zu kompensieren. Durch die Anordnung von drei Spulen ist es möglich, in jeder Raumrichtung X, Y, Z eine Kompensation durchzuführen.

Vorteilhaft ist wenigstens ein Sensor vorgesehen, der das magnetische Störfeld erfasst und/oder misst. Durch die Erfassung und/oder Messung des magnetischen Störfeldes kann die wenigstens eine Spule derart eingestellt werden, dass eine optimale Kompensation des magnetischen Störfeldes erfolgt.

Eine weitere vorteilhafte Ausführungsform der Erfindung sieht vor, dass eine Kompensationseinrichtung in der wenigstens einen Spule einen Strom steuert und/oder regelt in Abhängigkeit vom erfassten und/oder gemessenen magnetischen Störfeld. Diese Ausführungsform hat den Vorteil, dass die Kompensationseinrichtung sämtliche Steuerungs- und Regelungsvorgänge vornimmt. In der Kompensationseinrichtung gehen die von dem wenigstens einen Sensor erfassten Daten des magnetischen Störfeldes ein und die Kompensationseinrichtung kann die wenigstens eine Spule, das heißt den Strom in der wenigstens einen Spule derart steuern, dass eine optimale Kompensation erzielt wird.

Gemäß einer weiteren vorteilhaften Ausführungsform der Erfindung wird mit der wenigstens einen Kompensationsspule ein Feldvektor $\vec{B}$ mit einstellbarer Amplitude und Richtung erzeugt, um das magnetische Störfeld optimal zu kompensieren.

Eine weitere vorteilhafte Ausführungsform der Erfindung sieht vor, dass die Kompensationseinrichtung aus einer Antriebselektronik der Turbomolekularpumpe eine rotationssynchrone Kompensationsgrundfrequenz sowie erste bis n-te Oberschwingungen mit $n \geq 2$ ableitet. Mit einer Amplituden- und Phasenvariation der Ströme in den Spulen lässt sich das resultierende Feld $\vec{B}_{Res}$ minimieren, welches sich aus dem magnetischen Störfeld $\vec{B}_{St}$ und den von den Kompensationsspulen erzeugten Magnetfeld $\vec{B}_K(i_{X,Y,E})$ zusammensetzt, und zwar folgendermaßen

$$\vec{B}_{Res} = \vec{B}_{St} - \vec{B}_K\left(i_{X,Y,Z}\right).$$

Die Amplituden- und Phasenvariation der Ströme erfolgt nach folgender Gleichung

4

$$i_Z = i_{Z0} \cdot sin(\omega_0 \cdot t + \varphi_0) + i_{Z1} \cdot sin(2\omega_0 \cdot t + \varphi_1) + i_{Z2} \cdot sin(3\omega_0 \cdot t + \varphi_2) + \ldots$$

Das Gleiche ist in X- und Y-Richtung anzusetzen.

Gemäß einer weiteren vorteilhaften Ausführungsform der Erfindung wird mit einem Sensor eine Phasenreferenz der Vakuumpumpe erfasst.

Es ist auch möglich, die Phasenreferenz bei sensorlosen Rotorlageerkennungen oder Rotorphasenerkennungen durch Auswertung der Kommutierungsinformationen mit Hilfe eines Motormodells und Weitergabe der Phasenreferenz an eine Kompensationseinrichtung zu erfassen.

Das Störsignal muss in Phase mit der Rotordrehung aufgeschaltet werden. Hierzu muss die Phasenreferenz bekannt sein. Die Kompensation des Magnetfeldes muss derart erfolgen, dass sie um 180° phasenverschoben ist zu dem Störsignal des Magnetfeldes.

Mit dem erfindungsgemäßen Verfahren wird vorteilhaft das magnetische Störfeld wenigstens eines Magnetlagers oder wenigstens eines Elektromotors kompensiert. Das Magnetlager kann beispielsweise als Permanentmagnetlager oder als aktives Magnetlager ausgebildet sein.

Gemäß einer weiteren vorteilhaften Ausführungsform der Erfindung wird mit dem erfindungsgemäßen Verfahren das magnetische Störfeld mit wenigstens einer in und/oder an der Turbomolekularpumpe angeordneten Kompensationsspule kompensiert. Hierdurch erzielt man einen kompakten Aufbau der Turbomolekularpumpe. Weitere Merkmale und Vorteile der Erfindung ergeben sich anhand der zugehörigen Zeichnung, in der ein Ausführungsbeispiel einer erfindungsgemäßen Turbomolekularpumpe nur beispielhaft dargestellt ist. In der Zeichnung zeigen:

Fig. 1    eine Turbomolekularpumpe im Längsschnitt;

Fig. 2    eine schematische Darstellung der Ausrichtung der Kompensationsspulen.

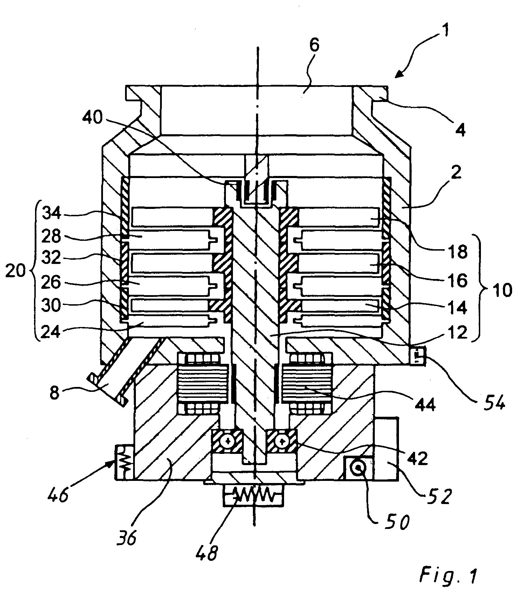

Fig. 1 zeigt einen Schnitt durch eine Turbomolekularpumpe 1, die einen Flansch 4 aufweist, der lösbar an einem Flansch einer zu evakuierenden Kammer (nicht dargestellt) befestigt ist. Durch eine Ansaugöffnung 6 wird Gas in die Pumpe 1 eingesaugt und durch den Auslass 8 ausgestoßen. Im Gehäuse 2 sind ein Rotor 10 und ein Stator 20 angeordnet, durch deren Zusammenwirken die Förderwirkung erreicht wird. Der Rotor 10 umfasst eine Welle 12, auf der eine vorvakuumseitige Rotorscheibe 14, eine mittlere Rotorscheibe 16 und eine hochvakuumseitige Rotorscheibe 18 vorgesehen sind, wobei jede der Rotorscheiben 14, 16, 18 einen aus einer Mehrzahl von Schaufeln bestehenden Schaufelkranz aufweist.

Die Welle 12 wird hochvakuumseitig durch ein Permanentmagnetlager 40 und vorvakuumseitig durch ein Wälzlager 42 drehbar unterstützt. Ein Antrieb 44 versetzt den Rotor in schnelle Drehung von einigen 10.000 Umdrehungen in der Minute. Der Stator umfasst eine vorvakuumseitige Statorscheibe 24, eine mittlere Statorscheibe 26 und eine hochvakuumseitige Statorscheibe 28. Diese sind durch Distanzringe 30, 32 und 34 in Bezug auf die Welle 12 axial voneinander beabstandet und mit den Rotorscheiben 14, 16, 18 alternierend angeordnet. Die Statorscheiben 24, 26, 28 besitzen ebenfalls Schaufelkränze. Die Anzahl von Rotor- und Statorscheiben hängt von den gewünschten vakuumtechnischen Parametern, wie Saugvermögen und Druckverhältnis zwischen Ansaugöffnung und Auslass ab.

An einem Gehäuseaufsatz 36 sind drei Spulen 46, 48, 50 angeordnet. Die Spulen 46, 48, 50 sind jeweils im 90°-Winkel zueinander angeordnet. Darüber hinaus ist eine Kompensationseinrichtung 52 vorgesehen. Die Kompensationseinrichtung 52 steuert über nicht dargestellte Leitungen die Ströme in den Spulen 46, 48, 50.

Darüber hinaus ist die Kompensationseinrichtung 52 mit einem Sensor 54 über eine nicht dargestellte Leitung verbunden. Mit dem Sensor 54 wird ein magnetisches Störfeld $\vec{B}_{St}$ erfasst. Die Spulen 46, 48, 50 erzeugen ein Kompensationsfeld $\vec{B}_K$, so dass ein resultierendes Feld

$$\vec{B}_{Res} = \vec{B}_{St} - \vec{B}_K(i_{X,Y,Z})$$

erzeugt wird. Dieses resultierende Feld wird von der Kompensationseinrichtung 52 minimiert, so dass das von dem Magnetlager 40 und/oder dem Motor 44 erzeugte magnetische Störfeld $\vec{B}_{St}$ keinen Einfluss auf weitere Geräte wie beispielsweise ein Elektronenmikroskop, an dem die Turbomolekularpumpe 1 angeschlossen ist, aufweist.

Das Kompensationsmodul 52 minimiert mittels einer Amplituden- und Phasenvariation der Ströme in den Spulen 46, 48, 50 das resultierende Feld $\vec{B}_{Res}$, indem aus der Antriebselektronik oder über eine Induktionsspule die rotationssynchrone Kompensationsgrundfrequenz abgeleitet wird, sowie die erste bis n-te Oberschwingung mit $n \geq 2$.

Die Amplituden- und Phasenvariation der Ströme in den Spulen 46, 48, 50 erfolgt nach folgender Gleichung:

$$i_Z = i_{Z0} \cdot sin(\omega_0 \cdot t + \varphi_0) + i_{Z1} \cdot \sin(2\omega_0 \cdot t + \varphi_1) + i_{Z2} \cdot \sin(3\omega_0 \cdot t + \varphi_2) + \ldots$$

Das Gleiche ist in X- und Y-Richtung anzusetzen.

Durch die Ströme in den Spulen 46, 48, 50 wird der Feldvektor $\vec{B}_K$ mit einstellbarer Amplitude und Richtung erzeugt. Mit $\vec{B}_K$ wird das magnetische Störfeld $\vec{B}_{St}$, welches von dem Magnetlager 40 und dem Antriebsmotor 44 der Turbomolekularpumpe erzeugt wird, kompensiert. Das Wechselstörfeld hat naturgemäß die gleiche Frequenz wie die Turbomolekularpumpe 1 und ist leicht nicht-sinusförmig.

Der Null- beziehungsweise Minimumabgleich des magnetischen Störfeldes erfolgt entweder automatisch durch gezielte Variation der oben genannten Parameter und Detektion des magnetischen Störfeldes $\vec{B}_{Res}$ mit dem Magnetfeldsensor 54. Es kann auch ein Abgleich durch Beobachtung des Verwischungsgrades an dem Gerät, an dem die Turbomolekularpumpe angeschlossen ist, erfolgen. Der Abgleich kann zum Beispiel am Elektronenmikroskop (nicht dargestellt) erfolgen.

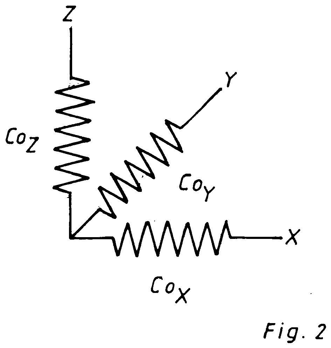

Gemäß Fig. 2 ist eine vorteilhafte Ausrichtung der drei Spulen 46, 48, 50 zueinander dargestellt. Die Wicklungen der Spulen sind entlang der X-, Y- und Z-Achse ausgerichtet, so dass die Spulen jeweils im 90°-Winkel zueinander angeordnet sind. Hierdurch ist eine optimale Kompensation des magnetischen Störfeldes möglich.

Bezugszahlen

| | |
|---|---|
| 1 | Turbomolekularpumpe |
| 2 | Gehäuse |
| 4 | Flansch |
| 6 | Ansaugöffnung |
| 8 | Auslass |
| 10 | Rotor |
| 12 | Welle |
| 14 | Rotorscheibe |
| 16 | Rotorscheibe |
| 18 | Rotorscheibe |
| 20 | Stator |
| 24 | Statorscheibe |
| 26 | Statorscheibe |
| 28 | Statorscheibe |
| 30 | Distanzring |
| 32 | Distanzring |
| 34 | Distanzring |
| 36 | Gehäuseteil |
| 40 | Permanentmagnetlager |
| 42 | Wälzlager |
| 44 | Antrieb |
| 46 | Kompensationsspule |
| 48 | Kompensationsspule |
| 50 | Kompensationsspule |
| 52 | Kompensationseinrichtung |
| 54 | Magnetfeldsensor |

**Patentansprüche**

**1.** Anordnung mit einer Turbomolekularpumpe mit einem Rotor und mit einem zum Antrieb des Rotors vorgesehenen Motor, **dadurch gekennzeichnet, dass** wenigstens eine Kompensationsspule (46, 48, 50) zur Kompensation eines von einem Bauteil (40, 44) der Turbomolekularpumpe (1) erzeugten magnetischen Störfeldes ($\vec{B}_{St}$) vorgesehen ist und dass die wenigstens eine Kompensationsspule (46, 48, 50) in und/oder an der Turbomolekularpumpe (1), entfernt liegend von dem Bauteil (40, 44), angeordnet ist.

2. Anordnung mit einer Turbomolekularpumpe nach Anspruch 1, **dadurch gekennzeichnet, dass** drei Kompensationsspulen (46, 48, 50) zur Kompensation des magnetischen Störfeldes ($\vec{B}_{St}$) des wenigstens einen Bauteiles (40, 44) angeordnet sind.

3. Anordnung mit einer Turbomolekularpumpe nach Anspruch 2, **dadurch gekennzeichnet, dass** die Magnetfelder der drei Kompensationsspulen (46, 48, 50) in drei Raumrichtungen, vorzugsweise jeweils im 90°-Winkel zueinander ausgerichtet sind.

4. Anordnung mit einer Turbomolekularpumpe nach einem der vorhergehenden Ansprüche, **dadurch gekennzeichnet, dass** die wenigstens eine Kompensationsspule (46, 48, 50) aus wenigstens einer Windung eines elektrischen Leiters gebildet ist.

5. Anordnung mit einer Turbomolekularpumpe nach einem der vorhergehenden Ansprüche, **dadurch gekennzeichnet, dass** wenigstens ein Sensor (54) zum Erfassen und/oder Messen des magnetischen Störfeldes ($\vec{B}_{St}$) oder einer Phasenreferenz vorgesehen ist.

6. Anordnung mit einer Turbomolekularpumpe nach einem der vorhergehenden Ansprüche, **dadurch gekennzeichnet, dass** wenigstens eine Stromversorgung für die wenigstens eine Kompensationsspule (46, 48, 50) und eine Kompensationseinrichtung (52) zum Steuern und/oder Regeln des Stromes in der wenigstens einen Kompensationsspule (46, 48, 50) in Abhängigkeit vom erfassten und/oder gemessenen magnetischen Störfeld ($\vec{B}_{St}$) vorgesehen ist.

7. Anordnung mit einer Turbomolekularpumpe nach einem der vorhergehenden Ansprüche, **dadurch gekennzeichnet, dass** die Kompensationseinrichtung (52) die Kompensationsspulen (46, 48, 50) einzeln ansteuernd ausgebildet ist.

8. Anordnung mit einer Turbomolekularpumpe nach einem der vorhergehenden Ansprüche, **dadurch gekennzeichnet, dass** das wenigstens eine ein magnetisches Störfeld erzeugende Bauteil ein Magnetlager (40), welches insbesondere als Permanentmagnetlager oder als aktives Magnetlager ausgebildet ist, oder ein Elektromotor (44) ist.

9. Verfahren zur Kompensation eines Magnetfeldes wenigstens eines in einer Turbomolekularpumpe angeordneten, ein magnetisches Störfeld erzeugenden Bauteiles der Turbomolekularpumpe, **dadurch gekennzeichnet, dass** wenigstens eine Kompensationsspule (46, 48, 50), vorzugsweise drei Kompensationsspulen ein magnetisches Störfeld ($\vec{B}_{St}$) des wenigstens einen Bauteiles (40, 44) der Turbomolekularpumpe (1) kompensiert/kompensieren, und dass die wenigstens eine Kompensationsspule (46, 48, 50) in und/oder an der Turbomolekularpumpe (1), entfernt von dem Bauteil (40, 44), angeordnet, ist.

10. Verfahren nach Anspruch 9, **dadurch gekennzeichnet, dass** eine Kompensationseinrichtung (52) in der wenigstens einen Kompensationsspule (46, 48, 50) einen Strom steuert und/oder regelt in Abhängigkeit vom erfassten und/oder gemessenen magnetischen Störfeld ($\vec{B}_{St}$).

11. Verfahren nach einem der Ansprüche 9 oder 10, **dadurch gekennzeichnet, dass** mit der wenigstens einen Kompensationsspule (46, 48, 50) ein Feldvektor ($\vec{B}_K$) mit einstellbarer Amplitude und Richtung erzeugt wird.

12. Verfahren nach einem der Ansprüche 9 bis 11, **dadurch gekennzeichnet, dass** die Kompensationseinrichtung (52) aus einer Antriebselektronik der Turbomolekularpumpe (1) eine rotationssynchrone Kompensations-Grundfrequenz sowie erste bis n-te Oberschwingungen $n \geq 2$ ableitet.

13. Verfahren nach einem der Ansprüche 9 bis 12, **dadurch gekennzeichnet, dass** mit einem Sensor eine Phasenreferenz der Turbomolekularpumpe (1) erfasst wird.

14. Verfahren nach einem der Ansprüche 9 bis 12, **dadurch gekennzeichnet, dass** das magnetische Störfeld wenigstens eines Magnetlagers oder wenigstens eines Elektromotors kompensiert wird.

**Claims**

1. Assembly with a turbomolecular pump with a rotor and with a motor provided to drive the rotor, **characterised in that** at least one compensation coil (46, 48, 50) is provided for compensating for a magnetic interference field ($\vec{B}_{St}$) generated by a component (40, 44) of the turbomolecular pump (1), and **in that** the at least one compensation coil (46, 48, 50) is arranged in and/or on the turbomolecular pump (1), distanced from the component (40, 44).

2. Assembly with a turbomolecular pump according to claim 1, **characterised in that** three compensation coils (46, 48, 50) are arranged for compensating for the magnetic interference field ($\vec{B}_{St}$) of the at least one component (40, 44).

3. Assembly with a turbomolecular pump according to claim 2, **characterised in that** the magnetic fields of the three compensation coils (46, 48, 50) are oriented relative to one another in three spatial directions, preferably in each case at an angle of 90° relative to one another.

4. Assembly with a turbomolecular pump according to any one of the preceding claims, **characterised in that** the at least one compensation coil (46, 48, 50) is formed of at least one winding of an electrical conductor.

5. Assembly with a turbomolecular pump according to any one of the preceding claims, **characterised in that** at least one sensor (54) is provided for detecting and/or measuring the magnetic interference field ($\vec{B}_{St}$) or a phase reference.

6. Assembly with a turbomolecular pump according to any one of the preceding claims, **characterised in that** at least one current supply is provided for the at least one compensation coil (46, 48, 50) and a compensation device (52) is provided for controlling or regulating the current in the at least one compensation coil (46, 48, 50) depending on the detected and/or measured magnetic interference field ($\vec{B}_{St}$).

7. Assembly with a turbomolecular-pump according to any one of the preceding claims, **characterised in that** the compensation device (52) is configured to control the compensation coils (46, 48, 50) individually.

8. Assembly with a turbomolecular pump according to any one of the preceding claims, **characterised in that** the at least one component generating a magnetic interference field is a magnetic bearing (40), which in particular is formed as a permanent magnetic bearing or as an active magnetic bearing, or is an electric motor (44).

9. Method for compensating for a magnetic field of at least one component of a turbomolecular pump arranged in the turbomolecular pump and generating a magnetic interference field, **characterised in that** at least one compensation coil (46, 48, 50), preferably three compensation coils, compensates/compensate for a magnetic interference field ($\vec{B}_{St}$) of the at least component (40, 44) of the turbomolecular pump (1), and **in that** the at least one compensation coil (46, 48, 50) is arranged in and/or on the turbomolecular pump (1), distanced from the component (40, 44).

10. Method according to claim 9, **characterised in that** a compensation device (52) controls or regulates a current in the at least one compensation coil (46, 48, 50) depending on the detected and/or measured magnetic interference field ($\vec{B}_{St}$).

11. Method according to either one of claims 9 or 10, **characterised in that** a field vector ($\vec{B}_K$) with adjustable amplitude and direction is generated with the at least one compensation coil (46, 48, 50).

12. Method according to any one of claims 9 to 11, **characterised in that** the compensation device (52) derives a rotationally synchronous compensation fundamental frequency and first to n$^{th}$ harmonic components with $n \geq 2$ from drive electronics of the turbomolecular pump (1).

13. Method according to any one of claims 9 to 12, **characterised in that** a phase reference of the turbomolecular pump (1) is detected with a sensor.

14. Method according to any one of claims 9 to 12, **characterised in that** the magnetic interference field of at least one magnetic bearing or at least one electric motor is compensated.

**Revendications**

1.  Agencement doté d'une pompe turbomoléculaire comprenant un rotor et un moteur prévu pour entraîner le rotor, **caractérisé en ce qu'**il est prévu au moins une bobine de compensation (46, 48, 50) destinée à compenser un champ magnétique parasite ($\vec{B}_{St}$) généré par un composant (40, 44) de la pompe turbomoléculaire (1) et **en ce que** ladite au moins une bobine de compensation (46, 48, 50) est disposée dans et/ou sur la pompe turbomoléculaire (1) de manière éloignée du composant (40, 44).

2.  Agencement doté d'une pompe turbomoléculaire selon la revendication 1, **caractérisé en ce qu'**il est prévu trois bobines de compensation (46, 48, 50) pour compenser le champ magnétique parasite ($\vec{B}_{St}$) dudit au moins un composant (40, 44).

3.  Agencement avec une pompe turbomoléculaire selon la revendication 2, **caractérisé en ce que** les champs magnétiques des trois bobines de compensation (46, 48, 50) sont orientés dans trois directions spatiales, de préférence respectivement à un angle de 90° l'une par rapport à l'autre.

4.  Agencement doté d'une pompe turbomoléculaire selon l'une quelconque des revendications précédentes, **caractérisé en ce que** ladite au moins une bobine de compensation (46, 48, 50) est constituée d'au moins un enroulement d'un conducteur électrique.

5.  Agencement doté d'une pompe turbomoléculaire selon l'une quelconque des revendications précédentes, **caractérisé en ce qu'**il est prévu au moins un capteur (54) destiné à détecter et/ou à mesurer le champ magnétique parasite ($\vec{B}_{St}$) ou une référence de phase.

6.  Agencement doté d'une pompe turbomoléculaire selon l'une quelconque des revendications précédentes, **caractérisé en ce qu'**il est prévu au moins une alimentation en courant destinée à ladite au moins une bobine de compensation (46, 48, 50) et un dispositif de compensation (52) destiné à commander et/ou à réguler le courant dans ladite au moins une bobine de compensation (46, 48, 50) en fonction du champ magnétique parasite détecté et/ou mesuré ($\vec{B}_{St}$).

7.  Agencement doté d'une pompe turbomoléculaire selon l'une quelconque des revendications précédentes, **caractérisé en ce que** le dispositif de compensation (52) est conçu pour commander individuellement les bobines de compensation (46, 48, 50).

8.  Agencement doté d'une pompe turbomoléculaire selon l'une quelconque des revendications précédentes, **caractérisé en ce que** ledit au moins un composant générant un champ magnétique parasite est un palier magnétique (40), qui est en particulier réalisé sous la forme d'un palier à aimant permanent ou sous la forme d'un palier magnétique actif, ou un moteur électrique (44).

9.  Procédé de compensation d'un champ magnétique d'au moins un composant d'une pompe turbomoléculaire disposé dans ladite pompe turbomoléculaire et générant un champ magnétique parasite, **caractérisé en ce qu'**au moins une bobine de compensation (46, 48, 50), de préférence trois bobines de compensation, compense/compensent de préférence un champ magnétique parasite ($\vec{B}_{St}$) dudit au moins un composant (40, 44) de la pompe turbomoléculaire (1), et **en ce que** ladite au moins une bobine de compensation (46, 48, 50) est disposée dans et/ou sur la pompe turbomoléculaire (1) de manière éloignée du composant (40, 44).

10. Procédé selon la revendication 9, **caractérisé en ce qu'**un dispositif de compensation (52) se trouvant dans ladite au moins une bobine de compensation (46, 48, 50) commande et/ou régule un courant en fonction du champ magnétique parasite détecté et/ou mesuré ($\vec{B}_{St}$).

11. Procédé selon l'une des revendications 9 ou 10, **caractérisé en ce qu'**un vecteur de champ ($\vec{B}_K$) à amplitude et direction réglables est généré au moyen de ladite au moins une bobine de compensation (46, 48, 50).

12. Procédé selon l'une quelconque des revendications 9 à 11, **caractérisé en ce que** le dispositif de compensation (52) déduit une fréquence fondamentale de compensation synchrone en rotation et des premier à n-ième harmoniques $n \geq 2$ à partir d'une électronique d'attaque de la pompe turbomoléculaire (1).

**13.** Procédé selon l'une quelconque des revendications 9 à 12, **caractérisé en ce qu'**une référence de phase de la pompe turbomoléculaire (1) est détectée au moyen d'un capteur.

**14.** Procédé selon l'une quelconque des revendications 9 à 12, **caractérisé en ce que** le champ magnétique parasite d'au moins un palier magnétique ou d'au moins un moteur électrique est compensé.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010052660 A1
- EP 2544214 A2
- JP 2003173755 B
- DE 102010013675 A1
- US 20070164627 A